**Europäisches Patentamt**

(19) **European Patent Office**

**Office européen des brevets**

(11) Veröffentlichungsnummer: **0 150 412**
**B1**

(12) EUROPÄISCHE PATENTSCHRIFT

(45) Veröffentlichungstag der Patentschrift:
**16.08.89**

(21) Anmeldenummer: **84115614.4**

(22) Anmeldetag: **17.12.84**

(51) Int. Cl.⁴: **H 04 N 7/13**

(54) **Verfahren zur Feststellung der Fehlerbündellänge.**

(30) Priorität: **12.01.84 DE 3400908**

(43) Veröffentlichungstag der Anmeldung:
**07.08.85 Patentblatt 85/32**

(45) Bekanntmachung des Hinweises auf die Patenterteilung:
**16.08.89 Patentblatt 89/33**

(84) Benannte Vertragsstaaten:
**AT BE CH DE FR GB IT LI NL SE**

(56) Entgegenhaltungen:
**DE-A- 2 445 508**
**DE-A- 3 029 190**
**DE-A- 3 114 275**
**GB-A- 1 500 232**
**GB-A- 1 548 001**

(73) Patentinhaber: **Siemens Aktiengesellschaft,**
**Wittelsbacherplatz 2, D-8000 München 2 (DE)**

(72) Erfinder: **Strehl, Herbert, Dipl.-Ing., Drozzaweg 15,**
**D-8000 München 70 (DE)**

**Beschreibung**

Die Erfindung betrifft ein Verfahren zur Feststellung der Fehlerbündellänge bei einer durch einen fehlerkorrigierenden Block-Code gesicherten Datenübertragung, bei dem jeweils Bitgruppen aufeinanderfolgender Codeblöcke zu einem Multiplex-Codeblock miteinander verschachtelt werden.

Bei der Übertragung von digitalen Bildsignalen werden fehlererkennende und fehlerkorrigierende Codes zur Datensicherung eingesetzt. Verwendet man fehlerkorrigierende Codes, so wird beim Überschreiten der Fehlerkorrekturfähigkeit die Bildqualität noch schlechter, als sie ohne Fehlersicherung wäre. Da bei der Übertragung von Bildsignalen nur wenige Bits zur Datensicherung verfügbar sind, ist eine Überschreitung der Korrekturfähigkeit aufgrund der Codierung oft nicht feststellbar. Bei der Übertragung von digitalen Bildsignalen kann mit einer üblichen Bitfehlerrate $\leq 10^{-6}$ gerechnet werden. Störungen treten praktisch nur als sogenannte Bündelstörungen auf. Diese betreffen jeweils eine Gruppe von eng benachbarten Bits. Durch die Feststellung der Fehlerbündellänge kann nicht nur die Qualität der Übertragungsstrecke überwacht werden, es kann darüber hinaus, wenn eine vorgegebene Fehlerbündellänge überschritten wird, noch ein Kriterium zur Umschaltung auf eine sogenannte Fehlerverdeckung abgegeben werden. Die von den gestörten Bits betroffenen Bildsignale werden dann durch ungestörte Bildsignale ersetzt, die aus den angrenzenden Bildsignalen des Fernsehbildes ermittelt werden oder den entsprechenden gespeicherten Bildschirm des letzten Fernsehbildes entsprechen.

Zur Verbesserung der Korrekturfähigkeit bei Bündelstörungen ist an sich bekannt, die Bits eines Blockcodes miteinander zu verschachteln, wie beispielsweise in ELECTRO-TECHNOLOGY, Januar 1968 Seiten 53 bis 62, insbesondere Seite 63, rechte Spalte beschrieben. Ein Hinweis auf die Messung von Fehlerbündeln fehlt hier jedoch.

Bei den bisher üblichen Verfahren zur Feststellung der Fehlerbündellänge wurde ein empfangener Prüftext mit einem fehlerfreien Prüftext verglichen und die Bitfehler durch Zählung festgestellt oder unter Berücksichtigung der Zeit statistisch ausgewertet. Dieses aufwendige Verfahren eignet sich nicht zur Feststellung der Fehlerbündellänge bei normalem Betrieb und daher auch nicht zur Gewinnung des Umschaltkriteriums für eine Bitfehlerverdeckung.

Es ist die Aufgabe der Erfindung, ein einfaches Verfahren zur Feststellung der Bitfehlerbündellänge während des normalen Betriebs anzugeben.

Diese Aufgabe wird dadurch gelöst, dass jeweils Bitgruppen mit soviel Bits miteinander verschachtelt werden, wie es der Fehlerbündelkorrekturfähigkeit des Blockcodes entspricht und dass empfangsseitig bei der Auswertung von Korrektursignalen für benachbarte Codeblöcke stets vorausgesetzt wird, dass ein einziges Fehlerbündel aufgetreten ist.

Bei diesem Verfahren wird die in öffentlichen Übertragungsnetzen (CCT) übliche relativ geringe Fehlerrate von zirka $\leq 10^{-6}$ und die Bündelfehlerstruktur vorteilhaft ausgenutzt. Durch die Verschachtelung von jeweils mehreren Bits eines Codeblockes wird zwar das Auflösungsvermögen herabgesetzt, das heisst man erhält nur eine gröbere Struktur über die Bitfehlerverteilung, die aber für die Funktionsweise der gesamten Übertragungseinrichtung auch nicht wesentlich ist. An den Grenzen der Multiplex-Codeblöcke kommt es ebenfalls zu Ungenauigkeiten. Da aber auch nur die Burstfehlerkorrekturfähigkeit innerhalb eines Multiplex-Codeblockes von Bedeutung ist, ist diese Messmethode dem Übertragungsverfahren bereits angepasst. Auch für die Umschaltung auf Fehlerverdeckung bei Überschreitung oder zumindest Annäherung an die Grenze der Korrekturfähigkeit ergibt dies Verfahren ein geeignetes Umschaltkriterium.

Werden nur wenige Codeblöcke ineinander verschachtelt, so ist dieses Verfahren auch leicht zu realisieren, da nur wenige Korrektursignale ausgewertet werden müssen. Die Auswertung kann teilweise hardwaremässig erfolgen, indem verschiedene Fehlerbündellängen über Logikschaltungen ermittelt werden. Für statistische Zwecke ergibt eine softwaremässige Auswertung der Fehlerverteilung, bei der jeder gestörte Codeblock und die dazugehörige Zeit mitberücksichtigt werden, natürlich ein genaueres Bild der Fehlerverteilung.

Es ist zweckmässig, dass ein Fehlerbündel und zusätzlich Einzelfehler korrgierender Code verwendet wird und dass nur Bitgruppen solcher Länge miteinander verschachtelt werden, dass die Einzelfehler-Korrekturfähigkeit erhalten bleibt.

Besonders bei der Übertragung von DPCM-codierten Bildsignalen können auch einzelne Fehler bereits deutlich sichtbare «Fehlerschleppen» bewirken. Wenn auch Einzelfehler zusätzlich zu Fehlerbündeln äusserst selten auftreten, so können sie doch bei einem allein Fehlerbündel korrigierenden Code zu deutlich sichtbaren Störungen führen. Wird zur Fehlersicherung beispielsweise ein Code verwendet, der ausser einem Bündelfehler noch zusätzlich einen Einzelfehler korrigieren kann, so wird diese Einzelfehlerkorrekturfähigkeit bei der Verschachtelung von Bitgruppen berücksichtigt. Die zusätzliche Einzelfehlerkorrekturfähigkeit soll auch dann noch vorhanden sein, wenn bereits ein Fehlerbündel aufgetreten ist.

Es ist zweckmässig, dass ein Blockcode mit einer Fehlerbündelkorrekturfähigkeit von 5 Bits verwendet wird. Die Verschachtelung von Bitgruppen mit jeweils 5 Bits eines Codewortes hat sich als günstiger Kompromiss zwischen Auflöse-Genauigkeit und Schaltungsaufwand herausgestellt.

Es ist vorteilhaft, dass ein Blockcode mit ca. 250 Informationsbits verwendet wird und jeweils aufeinanderfolgende Codeblöcke zu einem Multiplex-Codeblock verschachtelt werden.

Bei den zu erwartenden Bitfehlerhäufigkeiten ist die Korrekturfähigkeit eines solchen Codeblockes noch ausreichend und der Schaltungsaufwand ist gering.

Es ist zur Steigerung der Auslösungsfähigkeit zweckmässig, dass ein 2 Bits korrigierender Blockcode verwendet wird.

Werden jeweils 2 Bits umfassende Bitgruppen verschachtelt, so wird eine nahezu optimale Auflösung erreicht. Für statistische Zwecke kann mit Hilfe der Wahrscheinlichkeit mit grosser Exaktheit auf die tatsächliche Fehlerstruktur geschlossen werden. Bei dieser Weiterbildung des Verfahrens ist allerdings bereits eine softwaremässige Ermittlung der Fehlerstruktur vorteilhaft. Hierzu ist ein einfaches Rechenwerk ausreichend.

Es ist vorteilhaft, dass ein Fehler korrigierender Blockcode verwendet wird.

Bei diesem Verfahren wird eine optimale Auflösung erreicht.

Weitere vorteilhafte Weiterbildungen des Verfahrens sind in den übrigen Unteransprüchen angegeben.

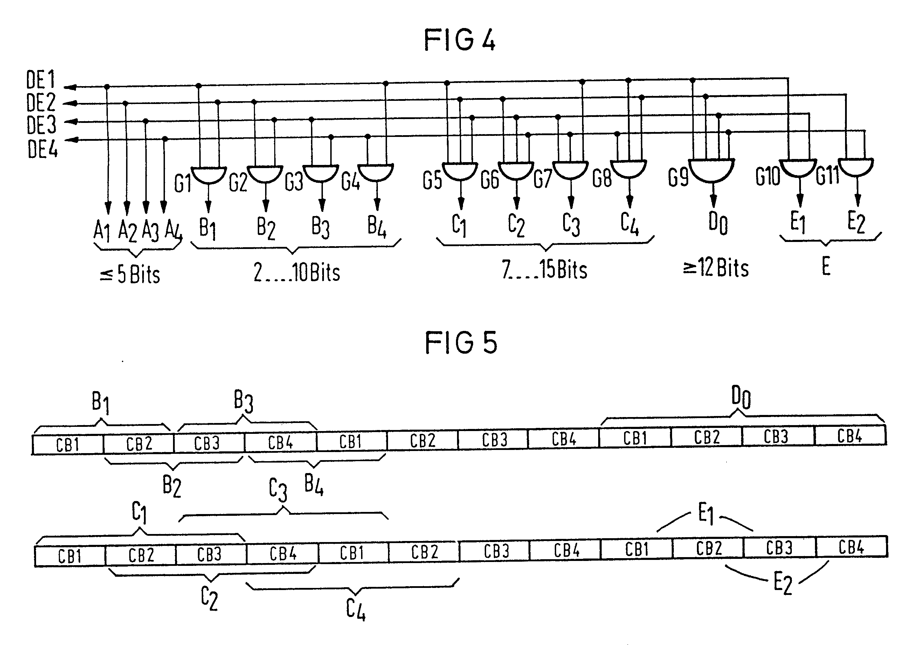

Das Verfahren wird anhand der Figuren 1 bis 5 näher erläutert.

Es zeigen

Fig. 1 ein Prinzipschaltbild zur Durchführung des erfindungsgemässen Verfahrens,

Fig. 2 die Verschachtelung von mehreren Codeblöcken zu einem Multiplex-Codeblock,

Fig. 3 eine Bündelstörung,

Fig. 4 eine hardwaremässige Auswertung von Bündelstörungen und

Fig. 5 ein Zeitdiagramm für mögliche Störungen.

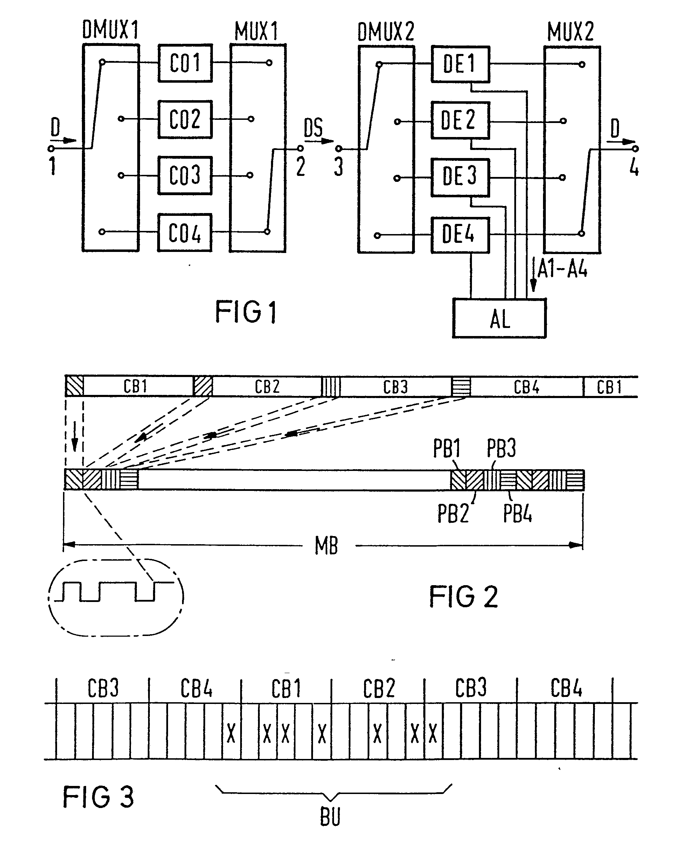

Das in Fig. 1 dargestellte Prinzipschaltbild soll die Funktionsweise des Verfahrens erläutern. Die zu übertragenden Datensignale D liegen am Eingang 1 eines Demultiplexers DMUX1 an. Dieser verteilt serielle Datensignale auf 4 Codierer CO1 bis CO4. Die Ausgänge der Codierer werden über einen Multiplexer MUX1 zusammengefasst und liegen am Ausgang 2 als gesichertes Digitalsignal DS an. Dieses Signal wird übertragen und gelangt im Empfänger zum Eingang 3 eines zweiten Demultiplexers DMUX2, der dies Signal wieder 5-Bit-weise nacheinander vier Decodierer DE1 bis DE4 zuführt. Die Datenausgänge dieser Decodierer werden über einen zweiten Multiplexer MUX2 wiederum zusammengefasst, so dass das ursprüngliche Datensignal D wieder am Ausgang 4 des zweiten Multiplexers MUX2 vorliegt. Jeder Decodierer DE1 bis DE4 weist ausserdem einen Korrekturausgang auf, der mit einer Auswertelogik AL verbunden ist.

Sendeseitig werden die Daten D in den Codierer jeweils in Codeblöcke aufgeteilt und durch einen Blockcode gesichert. Empfangsseitig werden Störungen durch Fehlerbündel duch die Decodierer beseitigt, die Auswertelogik ermittelt die Länge der Fehlerbündel. Auf weitere Details wie die Aufteilung bei der Übertragung von Bildsignalen in Luminanz- und Chrominanzsignale soll hier nur kurz eingegangen werden. Es ist beispielsweise denkbar, dass in den Codierer CO1 und CO2 das Luminanzsignal und in den weiteren Codierern CO3, CO4 das Chrominanzsignal verbreitet wird. Eine getrennte Ausgabe von Luminanz- und Chrominanzsignalen kann natürlich durch den zweiten Multiplexer MUX2 empfangsseitig erfolgen.

Ebenso soll die Funktion eines von der Auswertelogik AL abgegebenen Umschaltekriteriums $D_0$ kurz erwähnt werden. Wird durch die Auswertelogik AL festgestellt, dass die Fehlerbündellänge die maximale Korrekturfähigkeit nahezu erreicht oder überschreitet, so wird ein hier nicht erläutertes Fehlerverdeckungsverfahren für den gestörten Multiplex-Codeblock angewendet.

In Figur 2 ist die Verschachtelung von vier Codeblöcken CB1 bis CB4 dargestellt. Von jedem Codeblock CB1 bis CB4 werden zunächst die ersten fünf Bits miteinander verschachtelt, dann die zweiten fünf Bits und so weiter. Ausser der gesamten Information enthält der so entstandene Multiplex-Codeblock MB die Sicherungsbits PB1 bis PB4. Ebenso ist es natürlich möglich, das serielle Datensignal D durch den ersten Demultiplexer DMUX1 5-Bit-weise auf die Codierer CO1 bis CO4 zu verteilen.

In Figur 3 ist ein Fehlerburst eingezeichnet. Zunächst ist das letzte Bit einer Bitgruppe des Codierblocks CB4 gestört. Die Störungen verteilen sich dann weiter auf die nachfolgenden Bitgruppen der Codeblöcke CB1 bis CB3. Von dem Codeblock CB3 ist nur das erste Bit einer Bitgruppe gestört. Es sind jedoch vier aufeinanderfolgende Bitgruppen durch den Fehlerburst BU betroffen.

In diesem Fall geben alle Decodierer ein Korrektursignal ab. Es wird vorausgesetzt, dass ein einziger Fehlerburst vorliegt. Damit kann mit grosser Wahrscheinlichkeit die Aussage gemacht werden, dass eine Bündelstörung von mindestens zwölf Bits Länge vorliegt. Ebensogut kann sie natürlich auch zwanzig Bits umfassen.

In Figur 3 sind wesentliche Teile der Auswertelogik AL dargestellt. Die waagrechten Leitungen sind an die Korrekturausgänge der Decodierer DE1 bis DE4 angeschaltet. Die Korrektursignale sind hierbei mit $A_1$ bis $A_4$ bezeichnet. Ein Korrektursignal auf einer dieser Leitungen bedeutet ein Fehlerbündel zwischen einem Bit und fünf Bits. Die Ausgänge von vier UND-Gatter G1 bis G4 mit jeweils 2 Eingängen sind jeweils an die Korrekturausgänge DE1, DE2; DE2, DE3; DE3, DE4 und DE4 und DE1 angeschlossen. Ein Fehlersignal $B_1$ bis $B_4$ am Ausgang eines dieser Gatter bedeutet ein Fehlerbündel zwischen zwei und zehn Bits Länge. Weitere UND-Gatter G5 bis G8 mit jeweils drei Eingängen sind an jeweils drei Korrekturausgänge der Decodierer angeschlossen. Ein Fehlersignal $C_1$ bis $C_4$ am Ausgang eines dieser UND-Gatter bedeutet ein Fehlerbündel zwischen sieben und fünfzehn Bits Länge. Ein UND-Gatter G9 mit vier Eingängen ist an alle Korrekturausgänge der Decodierer angeschlossen. Ein Fehlersignal $D_0$

dieses UND-Gatters bedeutet, dass ein Fehlerbündel (BU) sämtliche Codeblöcke betrifft und somit eine Länge $\leq$ 12 Bits aufweist. Darüber hinaus sind hier noch jeweils die Korrektureingänge der Decodierer DE1 und DE3 sowie DE2 und DE4 durch zwei weitere UND-Gatter G10 und G11 zusammengefasst. Die Ausgangssignale $E_1$ bzw. $E_2$ an diesen Gattern lassen auf Einzelfehler E schliessen. An die Ausgänge dieser Gatter können Zählvorrichtungen angeschlossen werden. Es ist zweckmässig, zunächst Gatter derselben Gruppe, z. B. G1 bis G4 über ein ODER-Gatter zusammenzufassen. Bei der Auswertung muss berücksichtigt werden, dass bei einem langen Fehlerbündel ebenfalls Fehlersignale abgegeben werden, die kleinere Fehlerbündel anzeigen. Dies kann natürlich durch eine erweiterte Logikschaltung verhindert werden.

In Fig. 5 ist nochmals ein vergrösserter Ausschnitt aus einem Multiplex-Codeblock dargestellt. Die einzelnen Abschnitte stellen jeweils Bitgruppen der einzelnen Codeblöcke CB1 bis CB4 dar. Hier sind nochmals die Ausgangssignale der UND-Gatter bei verschiedenen Störungen dargestellt. Die Fehlersignale von UND-Gattern, die gleichzeitig kleinere Bitfehlerlängen anzeigen und deshalb nicht zusätzlich ausgewertet werden dürfen, wurden in dieser Darstellung fortgelassen.

Als Umschaltsignal zwischen Fehlerkorrektur- und einer Fehlerverdeckung dient das Ausgangssignal $D_0$ des UND-Gatters G9.

Die Codierung kann beispielsweise mit einem FIRE-Code erfolgen, bei dem ein Codeblock 257 Informationsbits und 14 Sicherungsbits umfasst.

Zur Erhöhung der Auflösung kann, wie bereits kurz erwähnt, die Anzahl der Bits in einer miteinander verschachtelten Bitgruppe bis auf ein Bit reduziert werden. Dies bedeutet eine höhere Anzahl von Codierern und Decodierern, die jedoch wiederum einfacher sind. Hierdurch ist eine beliebig genaue Feststellung der Fehlerbündellänge möglich. Die Auswertelogik wird natürlich entsprechend umfangreich. Es muss ebenfalls berücksichtigt werden, dass mehrere Bitgruppen innerhalb eines Fehlerbündels nicht gestört sind.

## Patentansprüche

1. Verfahren zur Feststellung der Fehlerbündellänge bei einer durch einen fehlerkorrigierenden Block-Code gesicherten Datenübertragung, bei dem jeweils Bitgruppen aufeinanderfolgender Codeblöcke zu einem Multiplex-Codeblock (MB) miteinander verschachtelt werden, dadurch gekennzeichnet, dass jeweils Bitgruppen mit soviel Bits miteinander verschachtelt werden, wie es der Fehlerbündelkorrekturfähigkeit des Blockcodes entspricht und dass empfangsseitig bei der Auswertung von Korrektursignalen für benachbarte Codeblöcke (CB1, CB2; CB2, CB3; ..., CB1, CB2, CB3 ...) stets vorausgesetzt wird, dass ein einziges Fehlerbündel (BU) aufgetreten ist.

2. Verfahren nach Anspruch 1, dadurch gekennzeichnet, dass ein Fehlerbündel und zusätzlich Einzelfehler korrigierender Code verwendet wird und dass nur Bitgruppen solcher Länge miteinander verschachtelt werden, dass die Einzelfehler-Korrektur-Fähigkeit erhalten bleibt.

3. Verfahren nach Anspruch 1 oder Anspruch 2, dadurch gekennzeichnet, dass ein Blockcode mit einer Fehlerbündelkorrekturfähigkeit von 5 Bits verwendet wird.

4. Verfahren nach Anspruch 3, dadurch gekennzeichnet, dass ein Blockcode mit ca. 250 Informationsbits verwendet wird und jeweils 4 aufeinanderfolgende Codeblöcke zu einem Multiplex-Codeblock verschachtelt werden.

5. Verfahren nach Anspruch 1, dadurch gekennzeichnet, dass ein 2 Bits korrigierender Blockcode verwendet wird.

6. Verfahren nach Anspruch 1, dadurch gekennzeichnet, dass ein 1 Fehler korrigierender Blockcode verwendet wird.

7. Verfahren nach einem der vorhergehenden Ansprüche, dadurch gekennzeichnet, dass die Fehlerbündellänge durch logische Gatterschaltungen ermittelt wird, deren Eingängen Korrektursignale (A1 bis A4) zugeführt werden.

8. Verfahren nach einem der vorhergehenden Ansprüche 1 bis 6, dadurch gekennzeichnet, dass die Fehlerbündellänge durch softwaremässige Auswertung der Korrektursignale (A1 bis A4) erfolgt.

9. Verfahren nach einem der vorhergehenden Ansprüche, dadurch gekennzeichnet, dass beim Überschreiten einer vorgegebenen Anzahl von Korrektursignalen aufeinanderliegender Codeblöcke (CB1–CB4) innerhalb eines Multiplex-Codeblockes ein Kriterium abgegeben wird, das die wahrscheinliche Überschreitung der Korrekturfähigkeit angibt.

10. Verfahren nach Anspruch 4, dadurch gekennzeichnet, dass bei 4 Korrektursignalen innerhalb eines Multiplex-Codeblocks (MB) ein Signal ($D_0$) zur Angabe der überschrittenen Fehlerbündelkorrekturfähigkeit abgegeben wird.

## Claims

1. Method of determining the error burst length in a data transmission protected by an error-correcting block code, in which in each case bit groups of successive code blocks are interleaved with one another to form one multiplex code block (MB), characterized in that in each case bit groups are interleaved with one another which have a number of bits corresponding to the error burst correction capability of the block code and in that, in the evaluation of correction signals for adjacent code blocks (CB1, CB2; CB2, CB3; ... CB1, CB2, CB3 ...) on the receive side, it is always assumed that a single error burst (BU) has occurred.

2. Method according to Claim 1, characterized in that a code correcting error bursts and additionally individual errors is used and in that only bit groups are interleaved with one another which have such a length that the single-error correction capability is retained.

3. Method according to Claim 1 or Claim 2, characterized in that a block code with an error burst correction capability of 5 bits is used.

4. Method according to Claim 3, characterized in that a block code with approximately 250 information bits is used and in each case 4 successive code blocks are interleaved to form one multiplex code block.

5. Method according to Claim 1, characterized in that a block code correcting 2 bits is used.

6. Method according to Claim 1, characterized in that a block code correcting 1 error is used.

7. Method according to one of the preceding claims, characterized in that the error burst length is determined by logic gate circuits, the inputs of which are supplied with correction signals (A1 to A4).

8. Method according to one of the preceding claims 1 to 6, characterized in that the error burst length ist produced by software evaluation of the correction signals (A1 to A4).

9. Method according to one of the preceding claims, characterized in that, when a predetermined number of correction signals of superimposed code blocks (CB1 – CB4) within a multiplex code block is exceeded, a criterion is emitted which specifies that the correction capability is probably exceeded.

10. Method according to Claim 4, characterized in that a signal ($D_o$) for specifying that the error burst correction capability is exceeded is emitted in the case of 4 correction signals within one multiplex code block (MB).

Revendications

1. Procédé pour déterminer la longueur d'un paquet d'erreurs dans une transmission de données protégée par un code de blocs correcteur d'erreurs, transmission dans laquelle des groupes de bits de blocs de codes successifs sont entrelacés ensemble en un bloc de codes multiplex (MB), caractérisé en ce que l'on entrelace à chaque fois ensemble des groupes de bits comprenant le nombre de bits correspondant à la capacité de correction de paquets d'erreurs du code de blocs et que, côté réception, lors de l'exploitation de signaux de correction pour des blocs de codes voisins (CB1, CB2; CB2, CB3; ... CB1, CB2, CB3 ...), on considère toujours qu'un seul paquet d'erreurs (BU) est apparu.

2. Procédé selon la revendication 1, caractérisé en ce que l'on utilise un code correcteur de paquets d'erreurs et en plus, d'erreurs indépendantes et que l'on entrelace seulement des groupes de bits d'une telle longueur que la capacité de correction des erreurs indépendantes est préservée.

3. Procédé selon la revendication 1 ou 2, caractérisé en ce que l'on utilise un code de blocs avec une capacité de correction de paquets d'erreurs de 5 bits.

4. Procédé selon la revendication 3, caractérisé en ce que l'on utilise un code de blocs avec environ 250 bits d'information et l'on entrelace chaque fois 4 blocs de codes successifs en un bloc de codes multiplex.

5. Procédé selon la revendication 1, caractérisé en ce que l'on utilise un code de blocs corrigeant 2 bits.

6. Procédé selon la revendication 1, caractérisé en ce que l'on utilise un code de blocs corrigeant 1 erreur.

7. Procédé selon une des revendications précédentes, caractérisé en ce que la longueur des paquets d'erreurs est déterminé par des circuits logiques à portes dont les entrées reçoivent des signaux de correction (A1 à A4).

8. Procédé selon une des revendications 1 à 6 précédentes, caractérisé en ce que la longueur des paquets d'erreurs est déterminé par l'exploitation par logiciel des signaux de correction (A1 à A4).

9. Procédé selon une des revendications précédentes, caractérisé en ce que, en cas de dépassement d'un nombre préfixé de signaux de correction de blocs de codes successifs (CB1–CB4) à l'intérieur d'un bloc de codes multiplex, un critère est délivré pour indiquer le dépassement probable de la capacité de correction.

10. Procédé selon la revendication 4, caractérisé en ce qu'un signal ($D_o$) pour indiquer le dépassement de la capacité de correction de paquets d'erreurs est délivré en cas d'apparition de 4 signaux de correction à l'intérieur d'un bloc de codes multiplex (MB).

DMUX1    MUX1        DMUX2          MUX2

CO1                    DE1

CO2                    DE2

D                 DS
1                 2  3            DE3          D
                                                4

CO3

CO4                    DE4

                                    A1–A4

                              AL

## FIG 1

CB1        CB2        CB3        CB4        CB1

                                        PB1    PB3

                                        PB2    PB4

MB

## FIG 2

CB3      CB4      CB1      CB2      CB3      CB4

          X  XX  X      X    XX

## FIG 3

BU

EP 0 150 412 B1

# FIG 4

DE1
DE2
DE3
DE4

G1 G2 G3 G4 G5 G6 G7 G8 G9 G10 G11

A1 A2 A3 A4    B1   B2   B3   B4    C1   C2   C3   C4    D0    E1   E2

$\leq 5\,\text{Bits}$    $2\ldots 10\,\text{Bits}$    $7\ldots 15\,\text{Bits}$    $\geq 12\,\text{Bits}$    E

# FIG 5

B1    B3    D0

| CB1 | CB2 | CB3 | CB4 | CB1 | CB2 | CB3 | CB4 | CB1 | CB2 | CB3 | CB4 |

B2    C3   B4

C1    E1

| CB1 | CB2 | CB3 | CB4 | CB1 | CB2 | CB3 | CB4 | CB1 | CB2 | CB3 | CB4 |

C2    C4    E2